Europäisches Patentamt

European Patent Office

Office européen des brevets

(19)

(11) Publication number: **0 032 279**
**B1**

(12) **EUROPEAN PATENT SPECIFICATION**

(45) Date of publication of patent specification: **28.09.83**

(21) Application number: **80300114.8**

(22) Date of filing: **11.01.80**

(51) Int. Cl.³: **H 01 L 27/10,**
**H 01 L 27/06, G 11 C 11/24**

(54) One transistor-one capacitor memory cell.

(43) Date of publication of application:
**22.07.81 Bulletin 81/29**

(45) Publication of the grant of the patent:
**28.09.83 Bulletin 83/39**

(84) Designated Contracting States:
**BE CH DE FR IT NL SE**

(56) References cited:
IBM TECHNICAL DISCLOSURE BULLETIN, vol.
21, no. 9, February 1979, pages 3828—3831
New York, U.S.A. V. L. RIDEOUT: "Double
polysilicon dynamic memory cell with
polysilicon bit line"
IBM TECHNICAL DISCLOSURE BULLETIN, vol.
22, no. 3, August 1979, pages 1240—1244
New York, U.S.A. V. L. RIDEOUT: "Polysilicon
bit line"
IBM TECHNICAL DISCLOSURE BULLETIN, vol.
20, no. 2, July 1977, pages 539—540 New
York, U.S.A. A. G. FORTINO et al.: "Polysilicon
drain mosfet memory cell"
IBM TECHNICAL DISCLOSURE BULLETIN, vol.
21, no. 1, June 1979, pages 190—193 New
York, U.S.A. R. T. DENNISON: "Dynamic
random access memory with read-only memory
characteristics at power-on time"

(73) Proprietor: **MOSTEK CORPORATION**
**1215 West Crosby Road**
**Carrollton Dallas, Texas 75006 (US)**

(72) Inventor: **Chan, Tsiu Chiu**
**1633 Camero**
**Carrollton, Texas (US)**

(74) Representative: **Kearney, Kevin David Nicholas**
**et al,**
**KILBURN & STRODE 30 John Street**
**London, WC1N 2DD (GB)**

(56) References cited:
IBM TECHNICAL DISCLOSURE BULLETIN, vol.
21, no. 6, November 1978, pages 2257—2259
New York, U.S.A. R. M. GEFFKEN et al.:
"Process for high-capacitance single-device
memory cell"
IEEE JOURNAL OF SOLID STATE CIRCUITS, vol.
SC-8, no. 5, October 1973, pages 310—318
New York, U.S.A. H. J. BOLL et al.: "Design of a
high-performance 1024-b switched capacitor
p.channel IGFET memory chip".

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

One transistor-one capacitor memory cell

## Field of the invention

The present invention relates to the field of dynamic memory cells utilized in integrated circuitry. More particularly, the present invention relates to a very high-density integrated circuit memory utilizing a single transistor and a single capacitor for each storage cell.

## Description of the prior art

Memories based on the use of metal oxide silicon field effect transistors (MOSFETs) commonly use a single device per bit. The memory package is typically organized as a two dimensional matrix of rows and columns. The gates of a multiplicity of the MOSFETs of the cells are connected to form a row. Similarly, a column is formed by coupling the source or drain regions of the MOSFET in the memory cells. Any number of rows and columns may be constructed in this manner. Depending upon whether the source or drain is connected to the column line, the source or drain remaining is capacitively coupled to ground. As the column or, as it is often called, the data line and the source or drain region, are constructed of the same material in the prior art they are constructed as one and the same. In a like sense, one of the capacitor plates also serves as the drain or source of the MOSFET in each memory cell. It is to be particularly noted that the performance of this storage device depends to a large part on the ratio of the capacitance of the storage device to the stray capacitance of the data line. Various prior art methods exist to increase this ratio and are discussed in United States Patent No. 4,012,757.

In the "IBM Technical disclosure Bulletin" Vol. 20, No. 2, of July 1977, there is disclosure of the concept of using an insuiated bit line as opposed to a diffused bit line in order to reduce the bit line to substrate capacitance and thus increase the cell capacitance to bit line capacitance ratio.

In the art of memory construction, there is a continuing effort to reduce the substrate area required for the memory cells. The memory cell area occupies a substantial portion of a memory circuit and constitutes a limitation on the reduction of size to be achieved. It is desirable to reduce the size of the memory cells in view of economical considerations, among other reasons. However, as the overall cell size is decreased, the ratio of cell capacitance to data line capacitance also significantly decreases, thereby affecting the performance of the device. Thus, the minimum size of a memory cell is limited by the minimum acceptable memory cell capacitance ratio. This size limitation, however, is not acceptable because the memory cells now in use in 16K bit RAMs cannot be used in a 64K bit RAM and still maintain the same package size. See U.S. Patent 4,012,757 for a memory cell commonly used in 16K bit Random Access Memories.

In a memory cell, the cell area is occupied by four elements. These four elements include the channel area of the transistor, the electrode of the capacitor, the field area isolating the cell from the other cells, and the data line. This is the structure as disclosed in U.S. Patent 4,012,757. A general object of the invention is to remove one of these elements from the substrate level and thereby provide decreased cell area requirements, without impairing the operation of the device, such as by decreasing the capacitance ratio.

## Summary of the invention

Accordingly the present invention provides an integrated circuit memory formed in a semiconductor substrate (70) having a multiplicity of memory cell pairs, each memory cell pair being coupled to one of a plurality of word select lines (50, 52) of said memory, each memory cell pair being coupled to two of a plurality of data lines (30, 32, 34) of said memory, each memory cell pair having a first region (61) including a first transmission channel disposed in said semiconductor substrate of said memory cell pair, each memory cell pair having a second region including a second transmission channel disposed in said semi-conductor substrate of said memory cell pair, each memory cell pair having conductive gate means (16) for controlling electrical current flowing in said first and second transmission channels, said gate means being insulatively disposed with respect to the first and second transmission channels in said first and second regions, respectively, said gate means having an electrical contact region (63) for connection to the said word select line (50); and, each memory cell pair having conductive capacitive means (82) insulatively disposed with respect to said first and second regions, respectively, said conductive capacitive means defining first and second capacitor regions operable for storing electrical charge, said first capacitor region constituting a portion of said first region and electrically coupled to said first transmission channel, and said second capacitor region constituting a portion of said second region and electrically coupled to said second transmission channel, characterised in that each of said memory cell pairs comprises:

first of the said two data lines (32) electrically coupled to the first region and insulatively disposed from said semiconductor substrate except at the point of electrical coupling (62);

second of the said two data lines (30) electrically coupled to said second region and insulatively disposed from said semi-conductor substrate except at the point of electrical coupling;

said conductive capacitive means being a continuous layer except at said first and second transmission channels and at points of electrical coupling of said first and second data lines with said first and second regions; respectively; and

said conductive capacitive means being electrically isolated from and disposed between said semiconductor substrate and said first and second data lines at the points of electrical coupling between the data lines the first and second regions, whereby electrical signals in the first and second data lines are decoupled from said semiconductor substrate.

Brief description of the drawings

Figure 1 is a schematic diagram of two one transistor-one capacitor memory cells.

Figure 2 is a top view of the conductive regions forming a first region in the substrate, including a drain, source, capacitor area, and a transmission channel.

Figure 3 is a top view showing the conductive capacitive means formed by a first polysilicon area.

Figure 4 is a top view showing data lines and conductive gates extending between two transmission channels of the transistors in a memory cell pair, the data lines and conductive gate means being formed by a second polysilicon layer.

Figure 5 is a cross-section of two memory cells of adjacent memory cell pairs.

Description of the preferred embodiments

The present invention is a one transistor-one capacitor memory cell structure used in integrated memory circuits to store a single information bit. The memory cell is a field effect transistor coupled to a capacitor which is similarly coupled to ground or other reference potential. One terminal of the field effect transistor and a first electrode of the capacitor are an integral unit. This capacitor electrode is physically formed in the substrate and not dependent upon inducement of an inversion field in the semiconductor surface. The second electrode of the capacitor is formed in a first polysilicon layer which may be a continuous layer throughout the memory array with exposure at the transmission channels of the field effect transistors and the point of contact between the data line and a terminal of the field effect transistor. The gate of each field effect transistor is formed in a second polysilicon layer, in which layer the data line is also formed. The data line is electrically isolated from the substrate layer except at the points in which it drops to make contact to the field effect transistor in a memory cell. By placing the data line in an upper layer of polysilicon, more substrate area is provided, thereby providing higher density while maintaining a desired ratio of memory cell capacitance of the data line stray capacitance. Further, the stray capacitance of the data line is decoupled from the substrate potential by the first polysilicon layer, and the problems of a changing substrate potential are avoided in this construction.

It should be clearly understood that the operation of the device is not dependent upon whether the device begins with a P-type or N-type substrate. This in turn effects whether a transistor terminal connected at a particular point is a source or a drain, as it also effects the polarity of the applied potential. Also, the term "semiconductor substrate" generally means a thick monocrystalline layer of silicon, an epitaxial layer of silicon grown in a supporting base, or a monocrystalline layer grown on an oxide layer which in turn is supported by a thick spinel or sapphire base.

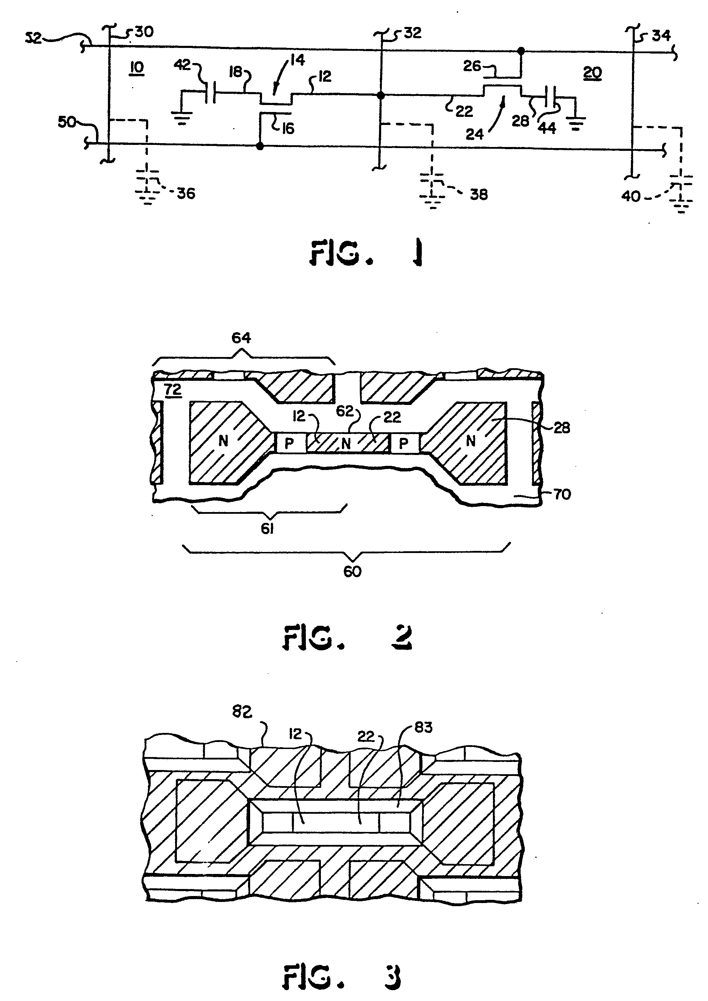

Referring now to the drawings, Figure 1 illustrates a portion of the memory array using a memory cell to store a single bit. This equivalent circuit includes two memory cells 10 and 20. Data lines 30, 32 and 34 have stray capacitances 36, 38 and 40. A source terminal 12 of a transistor 14 is connected to the data line 32 and a source terminal 22 of a transistor 24 of the memory cell 20 is connected to the data line 32. The gate 16 of the transistor 14 is connected to a word line 50, while the gate 26 of the transistor 24 is connected to a word line 52.

The drain terminal 18 of the transistor 12 is also connected to a first electrode of a capacitor 42 whose second electrode is connected to ground. Similarly, the drain terminal 28 of the transistor 24 is connected to the first electrode of a capacitor 44, whose second electrode is connected to ground. In practice, if the capacitor 42 stores a bit of information as a charge on the capacitor 42, a signal applied to the word line 50 causes the transistor 14 to become conductive. When the transistor 14 becomes conductive, the capacitor 42 then discharges to the data line 32 on which the bit of information may be read. Appropriate circuitry then carries the information to an output and may recharge the capacitor.

The strength of the signal on the data line 32 is in great part dependent on the ratio of the capacitance of capacitor 42 to the stray capacitance 38. However, as cell density increases, the area allowable for a large capacitor 42 decreases. In order to achieve a much greater available area for the capacitors of the memory cell, the data line is constructed in a first polysilicon layer separate from the substrate and a second separate polysilicon layer is used for a second electrode of the capacitor of the memory cell. This achieves a substantial increase in available area. In this manner capacitance is not decreased, while much greater memory storage in the same area becomes available. Further, because of the process steps involved in constructing two layers of polysilicon, the first polysilicon layer constituting a second electrode of the capacitor 42 may be grounded. This avoids the fluctuations inherent in any power supply, and further increases the operational effectiveness of the device. The uniqueness of these features can be seen with reference to the following figures.

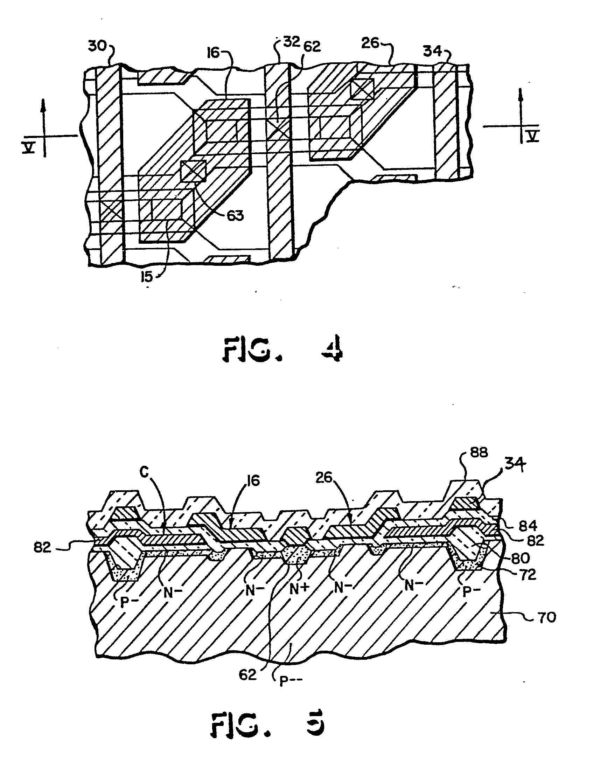

Figure 2 shows a region 60 comprised of N-type areas and P-type transmissions channels. This region 60 is disposed in a P-type substrate 70. In this region 60, the drains, sources, and channels of two field effect transistors for two memory cells are formed along with the two first electrodes of the two capacitors in the memory cells. The terminals 22 and 12 will also form a point of contact 62 for the data line 32 (see Figure 4). As can be seen, the terminals 12, 22, and the point of contact 62 are a common doped region. It should also be noted that only a portion of the full pattern of regions such as region 60 in a memory array is shown in Figure 2. The region 72 between the region 60 and a similar region such as 64 is a P-type doped region beneath a thick field oxide layer 80 to electrically isolate one region from the other. The left half 61 of a region 60 is designated as a first region disposed in the semiconductor substrate. An arbitrarily designated "memory cell pair" includes the right half of a different region 60 (belonging to the memory cell immediately below the cell which contains the first region) and is designated as a second region disposed in the semiconductor substrate.

In Figure 3, a first continuous layer of polysilicon 82 is grown. A window 83 is exposed to allow contact to be made to the transistor terminals 12 and 22. The transmission channels of the transistors are also exposed to allow a later process step to grow a gate region. The continuous layer 82 forms the top electrode of the capacitors 42 and 44 and every other capacitor in the memory array. This capacitive layer may then be grounded to provide a common reference potential for all cells in the memory array. An oxide layer 84 covers this layer of polysilicon.

A second layer 86 of polysilicon is grown as shown in Figure 4. This layer includes the data lines 30, 32 and 34 and the gates 16 and 26 of the transistors 14 and 24, respectively. As illustrated, the gates are common with another gate region of another memory cell of the "memory cell pair" extending from a different data line. Thus, for example, the gate 16 of the transistor 14 which is connected to data line 32 is in common with the gate of another transistor in the "memory cell pair" which is connected to data line 30. The "X's" within rectangles or contacts 63 in Figure 4 represent contact points. Although not shown in Figure 4, a word line 50 is routed horizontally and is electrically coupled to these gates via contact 63 and will act to turn on the transistors. However, the outputs will be sensed on different data lines. In this manner, a memory matrix is provided.

Further memory cell pairs will also be coupled to the same word line.

The data line 32 is embedded in the second polysilicon layer 86 and is insulated at all points other than where it makes contact with transistor pairs such as 14 and 24. At this contact point the oxide has been removed to allow an embedded contact such as contact 62 to be made. Because the embedded contact 62 involves transistor terminals already incorporated in the substrate and a thick oxide has been grown around the contact region through succeeding steps, a self-aligning contact results. This overcomes requirements of greater contact area to insure proper contact and achieves greater density due to the lesser area requirements. Further, with the data lines at a different level in the memory circuit above the substrate, the capacitors and transistors of the memory cells can be more closely packed, achieving greater cell density without compromising the desired capacitance ratio.

A cross-section taken through the lines 5—5 in Figure 4 is shown in Figure 5. The substrate 70 is P-doped and transistors 14 and 24 are implemented in the surface. The terminals 12, 18, 22 and 28 are N-type, along with the first electrode of the capacitors 42 and 44. A buffer area 72 is P-type. The thick field oxide layer 80 is grown over the substrate with a contact 62 to be formed in successive steps. The first polysilicon layer 82 forms the top electrode of the capacitors 42 and 44. This electrode is preferably grounded. The second polysilicon layer 86 forms the data lines 30, 32 and 34, and the gates 16 and 26 over the channels of the transistors. As seen, the data line 32 forms a contact 62 at the transistors while data lines 30 and 34 are stacked over the first polysilicon capacitive layer 82. The entire circuit is then coated with an insulating oxide 88. Finally, the circuit is supplied with appropriate contacts, metal interconnects for the word lines and a protective oxide layer, as is well known in the art.

Therefore, using the inventive concepts herein disclosed, a memory cell array with much greater density than heretofore available may be achieved without sacrificing capacitor area. Further, using this construction, better memory cell performance is obtained through a more effective capacitor. It is to be understood that further modifications and alterations may be made without departing from the spirit and scope of the present invention.

**Claims**

1. An integrated circuit memory formed in a semiconductor substrate (70) having a multiplicity of memory cell pairs, each memory cell pair being coupled to one of a plurality of word select lines (50, 52) of said memory, each memory cell pair being coupled to two of a plurality of data lines (30, 32, 34) of said memory, each memory cell pair having a first region (61) including a first transmission channel disposed in said semiconductor substrate of said memory cell pair, each memory cell pair having a second region including a second transmission channel disposed in said semi-conductor substrate of said memory cell pair, each memory cell pair having conductive gate means (16) for controlling electrical current flowing in said first and second transmission channels, said gate means being insulatively disposed with respect to the first and second transmission channels in said first and second regions, respectively, said gate means having an electrical contact region (63) for connection to the said word select line (50), said first transmission channel constituting a portion of and being electrically coupled to said first region, and said second transmission channel constituting a portion of and being electrically coupled to said second region: and, each memory cell pair having conductive capacitive means (82) insulatively disposed with respect to said first and second regions, respectively, said conductive capacitive means defining first and second capacitor regions operable for storing electrical charge, said first capacitor region constituting a portion of said first region and electrically coupled to said first transmission channel, and said second capacitor region constituting a portion of said second region and electrically coupled to said second transmission channel, characterised in that each of said memory cell pairs comprises:

first of the said two data lines (32) electrically coupled to the first region and insulatively disposed from said semiconductor substrate except at the point of electrical coupling (62);

second of the said two data lines (30) electrically coupled to said second region and insulatively disposed from said semiconductor substrate except at the point of electrical coupling;

said conductive capacitive means being a continuous layer except at said first and second transmission channels and at points of electrical coupling of said first and second data lines with said first and second regions, respectively; and

said conductive capacitive means being electrically isolated from and disposed between said semiconductor substrate and said first and second data lines except at the points of electrical coupling between the data lines and the first and the second regions whereby electrical signals in the first and second data lines are decoupled from said semiconductor substrate.

2. The integrated circuit memory as set forth in Claim 1 wherein said first and second capacitor regions are diffusion regions disposed in said semiconductor substrate.

3. The integrated circuit memory as set forth in any preceding Claim wherein each point of electrical coupling of said first and second data lines with said first and second regions, respectively, is an embedded contact, self-aligned to said first and second regions.

4. The integrated circuit memory as set forth in any preceding Claim wherein said semiconductor substrate is of P-type doped monocrystalline semiconductor.

**Patentansprüche**

1. Speicher in integrierter Schaltung, gebildet in einem Halbleitersubstrat (70) mit einer Vielzahl von Speicherzellenpaaren, wobei jedes Speicherzellenpaar mit einer eine Vielzahl von Wortauswählleitungen (50, 52) des Speichers gekoppelt ist, jedes Speicherzellenpaar mit zwei einer Vielzahl von Datenleitungen (30, 32, 34) des Speichers gekoppelt ist, jedes Speicherzellenpaar einen ersten Bereich (61) besitzt, der einen in dem Halbleitersubstrat des Speicherzellenpaars angeordneten ersten Übertragungskanal aufweist, jedes Speicherzellenpaar einen zweiten Bereich besitzt, der einen in dem Halbleitersubstrat des Speicherzellenpaars angeordneten zweiten Übertragungskanal aufweist, jedes Speicherzellenpaar eine leitende Gatevorrichtung (16) zum Steuern des in dem ersten und zweiten Übertragungskanal fließenden elektrischen Stromes aufweist, die Gatevorrichtung isoliert bezüglich des ersten und zweiten Übertragungskanals in dem ersten bzw. zweiten Bereich angeordnet ist, die Gate-Vorrichtung einen elektrischen Kontaktbereich (63) zur Verbindung mit der Wortauswahlleitung (50) aufweist, der erste Übertragungskanal einen Abschnitt des ersten Bereichs darstellt und elektrisch mit diesem gekoppelt ist, und der zweite Übertragungskanal einen Abschnitt des zweiten Bereichs darstellt und elektrisch mit diesem gekoppelt ist; und jedes Speicherzellenpaar eine leitende kapazitive Vorrichtung (82) aufweist, die isoliert bezüglich des ersten bzw. zweiten Bereichs angeordnet ist, wobei die leitende kapazitive Vorrichtung einen ersten und zweiten Kondensatorbereich definiert, der arbeitet zum Speichern elektrischer Ladung, der erste Kondensatorbereich einen Abschnitt des ersten Bereichs darstellt und elektrisch mit dem ersten Übertragungskanal gekoppelt ist und der zweite Kondensatorbereich einen Abschnitt des zweiten Bereichs darstellt und elektrisch mit dem zweiten Übertragungskanal gekoppelt ist, dadurch gekennzeichnet, daß jedes der Speicherzellenpaare aufweist:

die erste der beiden Datenleitungen (32) ist elektrisch gekoppelt mit dem ersten Bereich und isoliert angeordnet von dem Halbleitersubstrat mit Ausnahme des Punktes der elektrischen Kopplung (62);

die zweite der beiden Datenleitungen (30) ist elektrisch gekoppelt mit dem zweiten Bereich und isoliert angeordnet von dem Halbleitersubstrat mit Ausnahme des Punktes der elektrischen Kopplung;

die leitende kapazitive Vorrichtung ist eine kontinuierliche Schicht mit Ausnahme am ersten und zweiten Übertragungskanal und an Punkten elektrischer Kopplung der ersten und zweiten Datenleitung mit dem ersten bzw. zweiten Bereich; und

die leitende kapazitive Vorrichtung ist elektrisch isoliert von und zwischen dem Halbleitersubstrat und der ersten und zweiten Datenleitung angeordnet mit Ausnahme an Punkten elektrischer Kopplung zwischen den Datenleitungen und dem ersten und zweiten Bereich, wodurch elektrische Signale in der ersten und zweiten Datenleitung entkoppelt werden von dem Halbleitersubstrat.

2. Speicher in integrierter Schaltung wie in Anspruch 1 angegeben, wobei der erste und zweite Kondensatorbereich in dem Halbleitersubstrat angeordnete Diffusionsbereiche sind.

3. Speicher in integrierter Schaltung wie in einem vorhergehenden Anspruch angegeben, wobei jeder Punkt elektrischer Kopplung der ersten und zweiten Datenleitung mit dem ersten bzw. zweiten Bereich ein eingebetteter Kontakt ist, der selbstausgerichtet zum ersten und zweiten Bereich ist.

4. Speicher in integrierter Schaltung wie in einem vorhergehenden Anspruch angegeben, wobei das Halbleitersubstrat ein p-dotierter monokristalliner Halbleiter ist.

**Revendications**

1. Mémoire à circuit intégré formée dans un substrat en semi-conducteur (70) ayant une pluralité de paires de cellules de mémoire, chaque paire de cellules de mémoire étant couplée à l'une d'une pluralité de lignes de sélection de mots (50, 52) de le mémoire, chaque paire étant couplée à deux lignes d'une pluralité de lignes de données (30, 32, 34) de la mémoire, chaque paire comportant une première région (61) incorporant un premier canal de transmission disposé dans le substrat en semi-conducteur de la paire de cellules de mémoire, chaque paire présentant une seconde région incorporant un second canal de transmission disposé dans le substrat en semi-conducteur de la paire de cellules de mémoire, chaque paire ayant un moyen de porte conductrice (16) pour contrôler le courant électrique circulant dans les premier et second canaux de transmission, ce moyen de porte étant disposé de manière isolée par rapport aux premier et second canaux de transmission dans le première et seconde régions, respectivement, ce moyen de porte ayant une région de contact électrique (63) pour connexion à la ligne de sélection de mots (50), le premier canal de transmission constituant une partie de la première région et étant couplé électriquement à celle-ci, et le second canal de transmission constituant une partie de la seconde région et étant couplé électriquement à celle-ci; et chaque paire de cellules de mémoire ayant un moyen capacitif conducteur (82) disposé de façon isolée par rapport aux première et seconde régions, respectivement, ce moyen capacitif conducteur définissant des première et seconde régions de condensateur pouvant fonctionner pour stocker une charge électrique, la première région de condensateur constituant une partie de la première région et étant couplée électriquement au premier canal de transmission, et la seconde région de condensateur constituant une partie de la seconde région et étant couplée électriquement au second canal de transmission, caractérisée en ce que chacune despaires de cellules de mémoire comprend:

— une première des deux lignes de données (32) couplée électriquement à la première région et disposée de manière isolée par rapport au substrat en semi-conducteur à l'exception du point de couplage électrique (62);

— la seconde des deux lignes de données (30) couplée électriquement à la seconde région et disposée de manière isolée par rapport au substrat en semi-conducteur à l'exception du point de couplage électrique;

— le moyen capacitif conducteur étant une couche continue à l'exception des premier et second canaux de transmission et des points de couplage électrique des première et seconde lignes de données avec les première et seconde régions, respectivement; et

— le moyen capacitif conducteur étant isolé électriquement du substrat en semi-conducteur et des première et secondes lignes de données et étant disposé entre ce substrat en semi-conducteur et ces première et seconde lignes de données, à l'exception des points de couplage electrique entre les lignes de données et les première et seconde régions, d'où il résulte que des signaux électriques dans les première et seconde lignes de données sont désaccouplés du substrat en semi-conducteur.

2. Mémoire à circuit intégré selon la revendication 1, caractérisée en ce que les première et seconde régions de condensateur sont des régions de diffusion disposées dans le substrat en semi-conducteur.

3. Mémoire à circuit intégrée selon l'une quelconque des revendications précédentes, caractérisée en ce que chaque point de couplage électrique des première et seconde lignes de données avec les première et seconde régions, respectivement, est un contact noyé auto-aligné sur les première et seconde régions.

4. Mémoire à circuit intégré selon l'une quelconque des revendications précédentes, caractérisée en ce que le substrat en semi-conducteur est un semi-conducteur monocristallin dopé de type P.

FIG. 1

FIG. 2

FIG. 3

FIG. 4

FIG. 5